(19) Europäisches Patentamt
European Patent Office
Office européen des brevets

(11) **EP 4 521 128 A1**

(12) **EUROPEAN PATENT APPLICATION**
published in accordance with Art. 153(4) EPC

(43) Date of publication:
**12.03.2025 Bulletin 2025/11**

(51) International Patent Classification (IPC):
**G01R 31/34** (2020.01)    **H02K 11/21** (2016.01)

(21) Application number: 23799326.6

(22) Date of filing: **27.04.2023**

(86) International application number:
**PCT/ES2023/070272**

(87) International publication number:
**WO 2023/214105 (09.11.2023 Gazette 2023/45)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **02.05.2022 ES 202230400**

(71) Applicant: **Universitat Politècnica de València
46022 Valencia (ES)**

(72) Inventors:
• **BONET JARA, Jorge
46022 Valencia (ES)**
• **PONS LLINARES, Joan
46022 Valencia (ES)**

(74) Representative: **Maslanka Kubik, Dorota Irena
C/Vara de Rey 5 TER, 3, Oficina 5
26003 Logroño (La Rioja) (ES)**

(54) **METHOD AND DEVICE FOR ESTIMATING SPEED OF AN ASYNCHRONOUS MACHINE**

(57) **The present** invention relates to a non-invasive method for estimating the speed of an asynchronous machine, said method comprising the steps of:
a) specifying a signal capture time;
b) capturing a line current signal from the asynchronous machine during the specified capture time;
c) processing the current signal obtained and estimating the average operating speed by using the equation

$$s = \frac{O_v f_0 - f_{RSH}}{[O_v \mp v] \cdot f_0} \rightarrow n = \frac{60 f_0}{p}(1-s)$$, based

on an automatic detection of the position of the RSH, assigning them the parameters v and $O_V$; and
d) optionally, based on the estimated average speed, determining the position and amplitude of one or more fault-associated harmonics, the spectrum frequency of which depends on the speed, and providing a diagnosis based on the result.

The invention also discloses a suitable device for implementing said method.

FIG. 1

EP 4 521 128 A1

**Description**

<u>Field of the Invention</u>

The present invention generally relates to the field of asynchronous machines, and more specifically to a method and a device for estimating speed and diagnosing faults in asynchronous machines.

<u>Background of the Invention</u>

Line current analysis of asynchronous motors (known as MCSA or Motor Current Signature Analysis) is one of the diagnostic methods with the highest potential for detecting faults in induction motors. This is because it is a non-invasive method which can be applied without having to stop the production process and which can provide high reliability in the detection of certain faults (especially broken bars and eccentricity, but short circuits as well). The method itself consists of locating in the line current spectrum of the motor the harmonics generated by faults, the presence of which is to be detected; harmonics the position of which in the spectrum depends on the speed, and the significant amplitude of which defines the presence of the fault. To carry out this method, the technique uses the capture and frequency decomposition by means of the Fast Fourier Transform (FFT) of one or more of these currents.

More specifically, the diagnosis process as a whole can be divided into the following five steps:

- Capture: recording the line current or currents in a non-invasive manner to avoid stopping the production process.
- Decomposition: obtaining the current spectrum by means of FFT, by decomposing said current into its harmonics, each one at a different frequency and with a different amplitude.
- Location: defining in a precise and non-invasive manner the frequency of the fault harmonic, which, since it is a function of the speed, requires the prior measurement or estimation thereof to be able to distinguish it correctly from other nearby harmonics characteristic of a healthy state.
- Quantification: defining the amplitude of the fault harmonic, which grows with the presence of the fault.
- Diagnosis: applying a criterion that allows relating the amplitude of the fault harmonics detected with the severity of the fault caused.

The critical point of the process described is locating fault harmonics. As explained, the frequency of said harmonics depends on speed; therefore, a precise measurement or estimation of the speed, which allows performing said step with certain guarantees, is required. Due to the lack of an effective way of obtaining the speed, the step of locating today is acting like a bottleneck in the process, preventing being able to have a method of diagnosis based on MCSA that is reliable, precise, automatic, and valid for any motor. The drawbacks of the methods conventionally used to define speed during the step of locating are summarized below:

- Estimating the speed with a fixed physical sensor (encoder).

  • Not all motors in the industry work with a coupled physical sensor since they increase the price and decrease robustness of the motor (lower validity).
  • The measurements are affected by the operating and installation conditions; variations in temperature or the use of long transmission cables can change the results (lower reliability).
  • Coupling a sensor to the shaft is a highly invasive method.

- Estimating the speed with a manual physical sensor (tachometer).

  • Not all motors in the industry have the shaft accessible to be able to carry out the measurements (lower validity).
  • Precision of the measurements depends greatly on the operator's skill with the tachometer (lower reliability, lower automaticity).
  • The measurement of current must be synchronized with the measurement of speed.

- Estimating the speed without sensors, based on rotor slot harmonics (RSH).

  • Locating said harmonics in the spectrum is not trivial (lower validity).
  • It is necessary to know the number of rotor slots, which is a parameter rarely known in the industry (lower validity).
  • For use, it is also necessary to know parameter $v$ of the located RSH (lower validity). By way of clarification, parameter v is the order of the temporal harmonic present in the voltage generated by the corresponding RSH (it should be noted that a harmonic is a component of the signal the frequency of which is a multiple of the fundamental frequency).

- Estimating the speed without sensors, based on mixed eccentricity harmonics (MEH).

• Although any machine has an inherent level of eccentricity due to issues of manufacturing and assembly, the associated harmonics **do** not always manifest with sufficient amplitude to be distinguished in the spectrum, especially in machines with two pole pairs (lower validity).
• Even when they occur with a relatively significant amplitude in the spectrum, there may be around them harmonics associated with load oscillations leading to erroneous detections (lower reliability).
• Even if it were possible to detect them in an unequivocal manner, their narrow bandwidth leads to the speed estimations not being very precise: a small error in the estimation of their frequencies translates into a large error in the estimation of the speed (lower precision).

Document WO2019167086A1 discloses a non-invasive system for diagnosing induction motors by exclusively using line current. The fault detection system is based on measuring a current, digitizing the current, conditioning the signal, estimating the speed (which includes detecting the mixed eccentricity harmonics (MEH), and calculating the slip/speed from same), defining a band in which to search for the fault harmonics by using the estimated speed, detecting fault harmonics, and diagnosing.

Firstly, the method of estimating speed described in document WO2019167086A1 uses mixed eccentricity harmonics, which primarily have the three drawbacks described above.

Furthermore, the method of estimating speed described in document WO2019167086A1 only uses a single harmonic dependent on speed, which means that the method is not very robust, as the coherence of the estimation with the rest of the information available in the spectrum is not checked. As a consequence, it can fairly easily give rise to erroneous estimations of the speed due, for example, to having identified a harmonic as the MEH when it was not.

Moreover, the method described in document WO2019167086A1 requires knowing beforehand the number of slots, a parameter that is rarely known in the industry and which requires taking apart the motor or previously performing invasive testing to define such number. Namely, it uses said parameter to position the dynamic eccentricity harmonics.

Lastly, the method described in document WO2019167086A1 uses a band that is too broad to locate the fault harmonic (4 Hz centered on the frequency calculated based on the estimation of the speed by means of mixed eccentricity harmonics). By using such a broad search band (even broader than the bandwidth of the fault harmonic), the possibilities of detecting other non-fault-associated harmonics increase. Therefore, method reliability decreases.

Document CN111398814A discloses a system for fault detection and intelligent diagnosis for machines controlled by a soft starter. The system uses time-frequency information (speed, fault harmonics, current measurements, and voltage measurements) as a characteristic fault parameter to then diagnose the motor by means of artificial intelligence. The system carries out a method consisting of the following steps:

- synchronously measuring voltages and current for 1 second at 256 Hz,
- digitizing the signals,
- calculating the spectra,
- calculating the harmonic admittance (current spectrum / voltage spectrum),
- identifying the frequencies symmetrically distributed on two sides of a fundamental frequency,
- calculating the speed based on said frequencies.

The main drawback of the method described in document CN111398814A is that it requires measuring voltages, which is invasive, since the motor must be disconnected to safely couple the probes.

The method described in document CN11398814A uses harmonics which, considering the sampling frequency that is used (256 Hz), are different harmonics with respect to RSH harmonics. Based on the description given ("frequencies symmetrically distributed on two sides of a fundamental frequency"), it can be deduced that they are probably mixed eccentricity harmonics. As has already been discussed, these harmonics have three drawbacks affecting the applicability of the method, their reliability, and their precision.

Lastly, the method described in document CN11398814A uses a neural network. Therefore, it requires prior training, which increases the invasive character of the method, preventing an immediate use after connecting the device, prolonging the application of the related method and, accordingly, increasing its cost.

Document US2019324084A1 describes a system for fault detection in induction motors for the implementation thereof in controlled motors. The following are the basis of the method for diagnosis:

- The measured current contains the fundamental frequency and the fault frequency/frequencies.
- This current is modulated with a synthetic signal/signals with a frequency equal to the fault frequency/frequencies.

- To define the frequency of the synthetic signals, the speed sensor of the system is used.

- After modulating, four signals are obtained with the following characteristics:

  - Signal 1: slow and large (f_fundamental-f_synthetic).
  - Signal 2: fast and large (f_fundamental+f_synthetic)
  - Signal 3: slow and small (f_fault-f_synthetic).
  - Signal 4: fast and small (f_fault+f_synthetic).

- The third signal of these four signals is chosen to detect the fault, since it is the slowest one of all, thereby facilitating its detection by means of the zero-crossing technique, which is considerably sensitive to noise.

The method described in document US2019324084A1 does not estimate speed, but rather uses one of the physical sensors (encoder) present in the controller, with the drawbacks mentioned above for techniques of this type.

Lastly, the paper "Analysis of Non-Intrusive Rotor Speed Estimation Techniques for Inverter-Fed Induction Motors" (Chirindo Mathews; Khan Mohamed A; Barendse Paul, IEEE TRANSACTIONS ON ENERGY CONVERSION, 20200707 IEEE SERVICE CENTER, PISCATAWAY, NJ, US; vol. 36, no. 1, pp. 338 - 347) provides a review of non-invasive techniques for estimating speed to be used in estimating efficiency *in situ.* This paper does not propose any new method, but rather analyzes several existing methods, concluding that the best ones are those based on the detection of harmonics in the current spectrum as a result of their non-invasiveness and good precision (as compared, for example, with those based on vibration analysis). Furthermore, it shows by means of experimental testing that the techniques based on rotor slot harmonics (RSH) provide higher precision than those based on mixed eccentricity harmonics (MEH). Finally, it also highlights that albeit more precise, RSH techniques have the problem of requiring the number of rotor slots, which is a parameter rarely known in the industry.

Therefore, it would be desirable to have a device and method for estimating the speed of an asynchronous machine through the line current and performing a diagnosis thereof by locating the fault harmonics present in the spectrum and dependent on speed, which overcomes at least some of the mentioned drawbacks in the prior art. Namely, it would be desirable to have a device and method which allows performing said estimation of speed and diagnosis in an automatic, precise, and reliable manner for any asynchronous machine. Lastly, it would be desirable to be able to implement said method and device by using as the only starting information data indicated on the asynchronous machine nameplate, and in particular, without requiring any invasive step.

Summary of the Invention

The present invention solves the drawbacks of the prior art by disclosing a method and a device for estimating the speed and, optionally, for the diagnosis, of an asynchronous machine (both a motor and a generator), in a manner that is automatic, precise, reliable, generally applied, and non-invasive (based only on data known from the nameplate of the machine). The present invention estimates the speed of the asynchronous machine through its line current, and, optionally, performs a diagnosis of said machine by locating one or more fault harmonics present in the spectrum and dependent on speed.

According to a first aspect, the present invention discloses a non-invasive method for estimating the speed and, optionally, for the diagnosis, of an asynchronous machine. Namely, the method comprises the following steps:

a) specifying a signal capture time;
b) capturing a line current signal from the asynchronous machine during the capture time specified in step a);
c) processing the current signal obtained in step b) and estimating the average operating speed by using equation 0.6, based on an automatic detection of the position of the RSH using programmable processing means, assigning them the parameters $v$ and $O_V$;

$$s = \frac{O_v f_0 - f_{RSH}}{[O_v \mp v] \cdot f_0} \rightarrow n = \frac{60 f_0}{p}(1 - s) \qquad (0.6)$$

where

s is the slip,
$O_v f_0$ is the multiple of the fundamental frequency over which a given RSH is located when the slip (s) is zero,
$f_0$ is the fundamental frequency,
$f_{RSH}$ is the frequency of the RSH,

v the order of the temporal harmonic present in the voltage generated by the corresponding RSH,

$n$ is the average operating speed,

p is the number of pole pairs of the machine,

$O_V$ is the order of the odd harmonic of the fundamental frequency immediately higher than the frequency of the detected RSH, in the case of the asynchronous machine operating in motor mode; or the order of the odd harmonic of the fundamental frequency immediately lower than the frequency of the detected RSH, in the case of the asynchronous machine operating in generator mode;

with the particularity that $O_V$ relates to $f_{RSH,s}=0$ and to $f_0$ according to the following equation:

$$O_v = \frac{f_{RSH,s=0}}{f_0} \qquad (0.5)$$

where $f_{RSH,s=0}$ is the frequency of a given RSH when the slip (s) is zero; and

d) optionally, based on the average speed estimated in step c), defining the position and amplitude of one or more fault-associated harmonics, the spectrum frequency of which depends on the speed, and providing a diagnosis based on the result obtained.

The application of equation 0.6 allows estimating the average operating speed of the asynchronous machine without needing to know the number of slots of the rotor, or carrying out specific testing for obtaining same.

According to a second aspect, the present invention discloses a device for estimating the speed and, optionally, for the diagnosis, of an asynchronous machine, using a method according to the first aspect of the invention. The device comprises:

- a data acquisition system for acquiring data by means of a current probe, the current probe being suitable for capturing the physical signal of one of the line currents of the asynchronous machine, and the data acquisition system being configured to convert the physical signal captured by the current probe into a digital signal;
- a control unit configured to control the data acquisition system; and
- programmable processing means suitable for executing step c) of the method. Optionally, the programmable processing means are also suitable for executing step d) of the method.

Throughout the description and claims, the word "comprises" and variants thereof **do** not intend to exclude other technical features, additions, components, or steps. Furthermore, the word "comprises" includes the case "consists of". For those skilled in the art, other objects, advantages, and features of the invention will become apparent in part from the description and in part from implementing the invention. The following examples are provided by way of illustration, and are not intended to be limiting of the present invention. Furthermore, the present invention covers all the possible combinations of embodiments indicated here.

Brief Description of the Figures

The present invention will be best understood in reference to the following drawings illustrating preferred embodiments of the invention which are provided by way of example and should not be interpreted as being limiting of the invention in any way.

Figure 1 shows a portable device according to a first embodiment of the present invention.

Figure 2 shows an integrated device according to a second embodiment of the present invention.

Detailed Description of the Preferred Embodiments

The present invention relates to a method and a device for capturing and processing the line current of an asynchronous machine for estimating, through said current and in a non-invasive manner, the operating speed of the machine, and optionally detecting faults present in the machine which introduce spectrum frequencies of the current dependent on speed (such as, for example, broken bars, eccentricities, short circuits, etc.). The device disclosed herein can be generally applied to any asynchronous machine (both motors and generators), obtains results with high precision in a completely automated manner, and can obtain said results by having as the only starting information the nominal speed, frequency, and current indicated on the nameplate of the machine. Namely, the method and the device are based on the spectral detection of rotor slot harmonics (RSH).

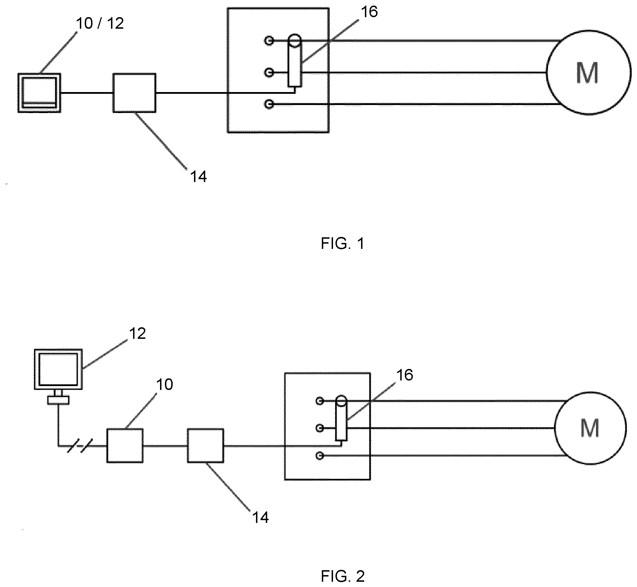

Firstly, a device according to the preferred embodiment of the present invention will be described in detail in reference to Figures 1 and 2. Said device consists of a data acquisition system (14) with a current probe (16) incorporated therein. Said probe (16) is suitable for capturing the physical current signal of one of the line conductors of the asynchronous machine. The data acquisition system (14) is configured to convert the physical signal captured by the current probe (16) into a digital signal.

The data acquisition system (14) is controlled by a control unit (10), such as a mini-computer. The control unit contains an algorithm for controlling the data acquisition system. The data acquisition system (14) and the control unit (10) can be separate elements or functionalities that are integrated in a single device.

The device also comprises means for estimating speed and, optionally, for the diagnosis of faults (essentially faults that introduce harmonics in the line current the frequency of which in the current spectrum depends on speed: broken bars, eccentricity, short circuits, etc.). Said means are programmable processing means configured to process the signal obtained by the data acquisition system (14). In accordance with the foregoing, the programmable processing means are suitable for estimating the speed of the asynchronous machine; and, optionally, they are also suitable for providing a diagnosis of faults of the asynchronous machine.

According to a first embodiment of the invention, the device is a device with a display (12) incorporated in the control unit (10). According to an example of this first embodiment, as shown in Figure 1, the device is a portable device which allows diagnosing faults and/or estimating speed of as many induction machines that are to be analyzed (in this case, induction motors), but which performs sporadic analyses of each machine (sporadic monitoring).

According to a second embodiment of the invention, the device is a device with an independent display (12) remotely connected to the control unit (10). According to an example of this second embodiment, as shown in Figure 2, the device is a fixed device that always analyzes the same induction machine (in this case, an induction motor), but allows the continuous monitoring of said machine in an industry 4.0 context. The device can be integrated, for example, in the machine to be monitored itself; preferably, in the switchboard that powers said machine.

In both cases, the display (12) constitutes display means for displaying the results obtained by the programmable processing means (i.e., the results obtained by the means for estimating speed and, optionally, for diagnosis, indicated above).

According to a preferred embodiment, the programmable processing means are incorporated in the control unit (10).

According to another preferred embodiment, the programmable processing means are independent of, and are remotely connected to, the control unit (10). In other words, they are located in another centralized computer that receives information from several control units (such as mini-computers) linked to respective specific asynchronous machines.

According to an additional embodiment, the device further comprises alarm means for providing an alarm in the case of detecting a fault in the asynchronous machine by means of the programmable processing means. In this case, it can be an audible alarm, a visual alarm, etc., as well as a SMS notification, e-mail notification, or the like delivered to the person responsible for the installation.

According to another additional embodiment, the device further comprises a storage unit to store at least one piece of data selected from the estimated average speed, the position and amplitude of the harmonics, and the result of the diagnosis.

According to another embodiment, the storage unit can store the captured current in addition to the at least one piece of data selected from the estimated average speed, the position and amplitude of the harmonics, and the result of the diagnosis.

Next, each of the physical elements constituting a device according to a preferred embodiment of the present invention are described in more detail.

Current probe: The function of a current probe is to capture the physical current signal of one of the lines that feed the machine. As minimum requirements, the measurement range of the probe is 0 - 500 A (or the range that suits the nominal current of the machine to be monitored); and the bandwidth of the probe is 0 - 10 kHz (or the range that suits the frequencies of the current to be captured).

Data acquisition system: The function of the data acquisition system is to convert the physical current signal captured by the probe into a digital signal for subsequent processing in the control unit (according to this embodiment, a mini-computer) or, according to an alternative, in a centralized computer that receives information from several control units.

Control unit: The first function of the control unit (according to this embodiment, the mini-computer) is that of controlling the data acquisition system; resulting in the captured current being saved. The control unit then proceeds to process same (in the case where the programmable processing means are incorporated in said control unit) by applying an algorithm which allows estimating the speed of, and/or diagnosing, the induction machine. When performing continuous monitoring, it must send the result to a centralized remote system. Alternatively, it can send the same current so that speed estimation and/or diagnosis are also performed remotely for the entire group of continuously monitored machines. In this case, the speed estimation and/or diagnosis algorithm can be executed in the centralized computer which controls each control unit.

Display: Depending on the variant, the display can be integrated in the control unit itself or in a control room where continuous monitoring of the rest of the data of the installation is performed. The function of the display is to show, through a graphical user interface, the results of the diagnosis and/or speed estimation, as well as to allow changing certain analysis parameters.

A non-invasive method for estimating the speed and, optionally, for the diagnosis, of an asynchronous machine, according to the present invention is described below in detail.

The method according to the preferred embodiment of the present invention comprises the following steps:

a) Specifying a signal capture time. Preferably, the user specifies the desired signal capture time, more preferably through the graphical interface, and gives the instruction to start the process. However, according to other options, it is possible for the device itself to specify the signal capture time, for example by means of a value preestablished as default setting, without the user having to specify it. According to a particular embodiment, the capture time is preestablished by the device (default setting), for example, at 200 s; and based on the default setting, it is possible for the user to modify the capture time according to their needs.

b) Capturing one of the line currents of the asynchronous machine for a period of time equal to the one specified in step a).

c) Processing the current signal obtained in step b) and estimating the average operating speed. Preferably, estimating the average operating speed is performed by using equation 0.6, based on an automatic detection of the position of the rotor slot harmonics (RSH), assigning them the parameters $v$ and $O_V$:

$$s = \frac{O_v f_0 - f_{RSH}}{[O_v \mp v] \cdot f_0} \rightarrow n = \frac{60 f_0}{p}(1 - s) \qquad (0.6)$$

where

s is the slip,

$O_v f_0$ is the multiple of the fundamental frequency over which a given RSH lies when the slip (s) is zero,

$f_0$ is the fundamental frequency,

$f_{RSH}$ is the frequency of the RSH,

v the order of the temporal harmonic present in the voltage generated by the corresponding RSH,

$n$ is the average operating speed,

p is the number of pole pairs of the machine,

$O_V$ is the order of the odd harmonic of the fundamental frequency immediately higher than the frequency of the detected RSH, in the case of the asynchronous machine operating in motor mode; or the order of the odd harmonic of the fundamental frequency immediately lower than the frequency of the detected RSH, in the case of the asynchronous machine operating in generator mode;

with the particularity that $O_V$ relates to $f_{RsH,s}=0$ and to $f_0$ according to the following equation:

$$O_v = \frac{f_{RSH,\,s=0}}{f_0} \qquad (0.5)$$

where $f_{RSH,s=0}$ is the frequency of a given RSH when the slip (s) is zero.

The application of equation 0.6 allows estimating the average operating speed of the asynchronous machine without needing to know the number of rotor slots, or carrying out specific testing to obtain same.

d) Optionally, based on the average speed estimated in step c), determining the position and amplitude of one or more fault-associated harmonics, the spectrum frequency of which depends on the speed, such as, for example, broken bars, eccentricities, short circuits, etc. (according to a particular embodiment, at least 20 seconds of capture is required for a correct display of these harmonics), and providing a diagnosis based on the result obtained.

e) Optionally, displaying the results obtained by the method, preferably on a display which is an integrated display for the portable version or a remote display for the continuous monitoring version.

f) Optionally, storing the results (preferably at least one piece of data selected from the estimated average speed, the position and amplitude of the harmonics, and the result of the diagnosis) in a database which the user can consult.

g) Optionally, providing an alarm in the case of detecting a fault during step d) of diagnosis.

By way of clarification, the following is described: During the time interval of the capture of a current signal, the speed of the machine is not perfectly stable, but rather experiences slight variations (a state in which the speed is perfectly constant does not exist). Therefore, when used herein, the term "average speed" refers to the average speed of the machine during the time of capture taking into account said variations.

Furthermore, optionally, it is also possible for the user to obtain information of the speed for every second of recorded signal, allowing the ability to observe whether load oscillations exist in the machine.

According to a preferred embodiment, the user also has the option of choosing between performing the method by way of continuous monitoring and by way of sporadic monitoring.

According to a preferred embodiment, when the method is applied for the first time to the machine, the processing of the current signal in step c) comprises performing setting operations for setting the internal parameters of the method, $O_V$ and v, such that, when the method is applied again at another time on the same machine, the set internal parameters are used without having to perform setting operations again, thereby considerably simplifying the processing of the current signal and, accordingly, the estimation of the average operating speed of the machine. Optionally, these setting operations can also be repeated every so often to update the internal parameters of the method, since, due to the degradation of the machine, some of the internal parameters may vary over time. The mentioned setting operations will be explained in further detail below according to a preferred embodiment, in which said setting operations are carried out in steps referred to as "steps of characterizing".

Preferably, to set the internal parameters of the method, the current signal is captured in steady state with a load index greater than 5% (in terms of mechanical power) and a minimum duration of 50 s. Preferably, in the case that the method is applied at a time other than during the setting operations, by using the set internal parameters without performing the setting operations again, the following options are contemplated:

- If only the average operating speed is to be estimated without performing a diagnosis, there is no minimum signal capture time.
- If, in addition to estimating the average operating speed, a diagnosis is to be performed, the current signal capture is performed, preferably, for a minimum of 20 seconds.

Generally, the method according to the preferred embodiment of the present invention can be divided into two clearly different parts: an algorithm for controlling the current data acquisition system; and an algorithm for estimating the speed and/or diagnosis of faults with spectrum frequencies that are a function of speed (broken bars, eccentricity, short circuits, etc.).

*Algorithm for controlling the current data acquisition system.*

This is an algorithm programmed to serve as a communication interface between the control unit and the data acquisition system. Furthermore, it allows the user to select the following parameters:

- Capture mode: sporadic analysis or continuous monitoring (in this second case, the interval between captures is specified).
- Measurement scale: amperes maximum to be captured (based on the clamp used and on the nominal current of the machine to be measured).
- Capture time: preferably a minimum of 50 seconds for the diagnosis in stable steady state.
- Sampling frequency: typically fixed at 10 kHz.

However, according to a particular embodiment, the algorithm has recommended settings so that the user only has to choose between the capture mode and, in case of continuous monitoring, the monitoring interval.

*Algorithm for estimating speed and/or diagnosis.*

This is an algorithm which allows estimating the speed in asynchronous machines (step c described above) and, optionally, their diagnosis (step d described above) (for example, detection of broken bars, eccentricities, and other faults with frequencies dependent on speed, such as short circuits); doing all this in a precise, automatic, non-invasive manner, and which furthermore only requires knowing the nominal frequency, speed, and current of the machine, parameters which are all known since they are included in the nameplate, which confers to the method its widespread applicability. This is achieved as a result of the algorithm being based on the detection of rotor slot harmonics (RSH).

RSH are a set of harmonics induced in the line current, the frequencies of which depend on a series of parameters, as shown in the following formula:

$$f_{RSH} = \left[ k \frac{R}{p}(1-s) \pm v \right] f_0 \tag{0.1}$$

which can also be written as:

$$f_{RSH} = \left[k\frac{R}{p} \pm v\right]f_0 - k\frac{R}{p}sf_0 \qquad\qquad (0.2)$$

where k is a positive natural number 1, 2, 3..., p is the number of pole pairs of the machine, s is the slip, v =1, 3, 5,..., is the order of the temporal harmonic (multiple of the fundamental frequency) present in the voltage generated by the corresponding RSH, $f_0$ is the fundamental frequency (or main harmonic of the supply voltage), and R is the number of rotor slots/bars.

As mentioned, k is a positive natural number. More specifically, k is an index which helps to express, for example, the relative order h of the field harmonics generated by the rotor of the asynchronous machine, as shown in the following equation h = $(k \cdot R/p) \pm 1$, by way of descriptive example. These field harmonics end up inducing in the stator the so-called rotor slot harmonics (RSH), for which reason the k index is in the formula of the corresponding frequency thereof.

The number of rotor slots is, in theory, an unknown parameter, since it is not included in the nameplate or in catalogues, and it is not easy to obtain said information directly from the manufacturer either. Therefore, to have an automatic and non-invasive method, this parameter must be removed from the equation. To remove R from the equation, it is considered that formula 0.2 in ideal no-load condition (s=0) can be rewritten as:

$$f_{RSH,s=0} = \left[k\frac{R}{p} \pm v\right]f_0 = O_v f_0 \qquad\qquad (0.3)$$

where $f_{RSH,s=0}$ is the frequency of a given RSH when the slip (s) is zero.

As mentioned, $O_v f_0$ (where subscript v refers to the value of v taken) is the multiple of the fundamental frequency over which a given RSH lies when the slip is zero. RSH only manifest at a high amplitude in the line current spectrum for odd numbers of k when $R/p$ is even, and for even numbers of k when $R/p$ is odd. Therefore, for significant RSH, $k \cdot R/p$ is the product of multiplying an even number by an odd number; if another odd number (v) is added or subtracted, the result, $O_V$ (see equation 0.3), is always an **odd** number. In short, in ideal no-load condition (s=0) the RSH that can lie in **odd** multiples of the fundamental frequency $O_V f_0$; and in load condition, in motor mode (s>0) they lie to the left thereof (see equation 0.2), whereas in generator mode (s<0) they lie to the right thereof. By way of clarification, **odd** multiple of the fundamental frequency (also known as **odd** harmonic of the fundamental frequency) must be understood as the resultant frequency of multiplying the fundamental frequency by an **odd** number, as is commonly used in the field of electrical engineering.

Next, equation 0.2 can be reformulated for any operating speed as:

$$f_{RSH} = O_v f_0 - [O_v \mp v] \cdot s \cdot f_0 \qquad\qquad (0.4)$$

The following information can be extracted from this last equation:

- If equation 0.4 is rewritten as $f_{RSH} = O_v f_0 - ksf_0 R/p$, it can be observed that the distance of an RSH with respect to $O_v f_0$ is equal to $ksf_0 R/p$. Since $R/p$ is not variable and $sf_0$ (slip frequency) is the same for all RSH (v = 1, 2, 3...), if said RSH are associated with the same k, the distance (in Hz) between the frequency of the RSH and the frequency of the **odd** multiple of the fundamental frequency $O_v f_0$, is the same for all the RSH.
- Going into details of the above for full-load: from no-load to full-load, any RSH is displaced a distance equal to $[O_v \mp v] \cdot s_N \cdot f_0$ Hz, left (motor) or right (generator), with respect to its no-load position $O_v f_0$ (odd-multiple frequency of the fundamental frequency); where $s_N$ is the nominal slip value (i.e., the full-load slip value).
- After having located an RSH, it is easy to locate the **odd** multiple of the fundamental frequency $O_v f_0$ to the right (in motor mode, which is the most common) or to the left (in generator mode), and, by knowing the frequency of the fundamental frequency $f_0$, it is easy to calculate the parameter $O_V$, with only parameter v remaining to be determined with respect to said RSH, as the number of rotor slots R has been removed from the equation.

Next, there is described a descriptive example that serves to illustrate the concept of the location of the **odd** multiple of the fundamental frequency that lies to the right (in motor mode) or to the left (in generator mode) of the RSH located and the calculation of parameter $O_V$; and which furthermore serves to show a possible particular embodiment to carry out said actions:

Assume that an asynchronous machine is working in motor mode with a fundamental frequency $f_0$=50 Hz (which frequency can be easily obtained, as it is the maximum peak of the spectrum), and that an RSH has been located at 1435 Hz.

In this case, the multiples of the fundamental frequency close to the RSH are the following:

$f_0 \cdot 27 = 50 \cdot 27 = 1350$ Hz; $f_0 \cdot 28 = 50 \cdot 28 = 1400$ Hz; $f_0 \cdot 29 = 50 \cdot 29 = 1450$ Hz; $f_0 \cdot 30 = 50 \cdot 30 = 1500$ Hz; $f_0 \cdot 31 = 50 \cdot 31 = 1550$ Hz.

So the odd harmonic of the fundamental frequency immediately higher than the RSH (i.e., the odd multiple of the fundamental frequency $O_v f_0$ to the right the RSH located) is at 1450 Hz. This is the frequency of the RSH when the slip is zero (i.e., $f_{RSH,s=0}$, which is the numerator in equation 0.5).

Equation 0.5 is applied to obtain Ov. In other words, the frequency of the harmonic of the fundamental frequency immediately higher than the RSH is divided by the fundamental frequency $f_0$. Therefore, Ov = 1450 / 50 = 29.

A fast way of locating the odd multiple of the fundamental frequency that lies to the right of the RSH located and calculating the parameter $O_V$ in the previous case (i.e., asynchronous machine working in motor mode with a fundamental frequency f0=50 Hz and an RSH has been located at 1435 Hz) is to divide the frequency of the harmonic of the fundamental frequency immediately higher than the RSH (1435 Hz) by the fundamental frequency (50 Hz), and to round to the nearest odd multiple of the immediately higher fundamental frequency. In other words, 1435 / 50 = 28.7, and this is rounded, obtaining Ov = 29.

Next, a preferred embodiment to perform step c) described above is described. Taking into account that the fundamental frequency can be easily obtained, since it is the peak with the highest amplitude in the current spectrum, and that the number of rotor slots has been removed from the equation, it is only necessary to apply an algorithm to perform step c), comprising namely the following steps:

i) Locating sets of RSH family candidate harmonics (RSH: rotor slot harmonics), an RSH family being a set of RSH associated with the same k index value.

For the purpose of simplifying the terminology used, the term "set of candidates" is also used herein to refer to a "set of RSH family candidate harmonics". Furthermore, the term "RSH candidate harmonic" is also used to refer to a harmonic belonging to a set of RSH family candidate harmonics.

The k index is used to differentiate sets of RSH family candidates, as the RSH associated with $k$=1 are at a distance X from the odd multiple of the fundamental frequency (more specifically, at a distance X from the odd multiple of the immediately higher fundamental frequency in the case of the asynchronous machine operating in motor mode; or from the odd multiple of the immediately lower fundamental frequency in the case of the asynchronous machine operating in generator mode), the RSH associated with $k$=2 are at a distance of 2X, and so on and so forth. According to the preferred embodiment of the present invention, the value of the k index is not relevant in this step, rather the RSH candidate harmonics of the same set of candidates are associated with the same k index, i.e., they are separated by the same distance with respect to the odd multiple of the immediately higher fundamental frequency in the case of the asynchronous machine operating in motor mode; or with respect to the odd multiple of the immediately lower fundamental frequency in the case of the asynchronous machine operating in generator mode.

ii) Calculating the parameter $O_V$ associated with each RSH candidate harmonic of each located set of candidates, where $O_V$ is the order of the odd harmonic of the fundamental frequency immediately higher than the frequency of the RSH candidate harmonic, in the case of the asynchronous machine operating in motor mode; or the order of the odd harmonic of the fundamental frequency immediately lower than the frequency of the RSH candidate harmonic, in the case of the asynchronous machine operating in generator mode; with the particularity that $O_V$ relates to $f_{RSH,s=0}$ and with $f_0$ according to the following equation 0.5:

$$O_v = \frac{f_{RSH,s=0}}{f_0} \qquad\qquad (0.5)$$

where $f_{RSH,s=0}$ is the frequency of a given RSH candidate harmonic when the slip (s) is zero.

iii) Determining the parameter v associated with each RSH candidate harmonic of each located set of candidates; and

iv) Determining which of all the sets of candidate harmonics is the true RSH family.

v) Estimating the average operating speed $n$ by using equation 0.6:

$$s = \frac{O_v f_0 - f_{RSH}}{[O_v \mp v] \cdot f_0} \rightarrow n = \frac{60 f_0}{p} (1 - s) \qquad (0.6)$$

According to a preferred embodiment of the present invention, after having determined which of all the sets of candidates is the true RSH family in step iv), the parameters $O_V$ and v of the RSH of said family are stored for later use, such that when the method is applied again at another time on the same machine, step v) of estimating the average operating speed n based on the stored parameters $O_V$ and v is performed directly, instead of performing steps i), ii), iii), and iv) again.

Next, some of the steps of the method will be described in further detail.

*Locating sets* of *RSH family candidate harmonics (step i).*

A family of rotor slot harmonics is defined as the set of said harmonics linked to the same k index. Next, the part of the algorithm the objective of which is to identify the frequencies of the RSH candidate harmonics present in the machine is described. According to a preferred embodiment, step i) comprises the following actions:

- Obtaining the spectrum: The algorithm calculates the fast Fourier transform (FFT) of the signal preferably by applying zero-padding (to increase the frequency resolution), which is known as the zero-padding technique.

- Performing a prior filtering and estimating the noise level: Preferably, the frequency is reduced to $200f_0$ Hz through a Chebyshev 8th order low-pass IIR filter, and, subsequently, the noise level is estimated through the average value of the spectral density of the current, multiplied by an experimentally obtained coefficient of 0.872.

- Filtering the noise: All the harmonics below the noise level are removed.

- Optionally, filtering harmonics of the converter: The harmonics produced by the converter are filtered in the case that the machine is powered by one. To that end, firstly, the harmonics of the converter are estimated through the theoretical formula thereof. Then a band is centered around same, and everything contained in said band is removed.

- Defining RSH candidate harmonic search windows: The spectrum is subdivided into windows of amplitude $[f_0(2m-1) f_0 (2m+1)]$, where m is an integer increasing by one from 4, until covering the spectrum.
  Next, the manner in which the RSH candidate harmonic search windows are defined is described in further detail based on a descriptive example: after the signal has been filtered, the sampling frequency is reduced to a $200f_0$ Hz (as indicated above). Next, the RSH candidate harmonic search windows are defined by means of $[f_0(2m-1) f_0(2m+1)]$, increasing *m* by one from 4, giving rise to the search windows $[7f_0 9f_0]$, $[9f_0 11f_0]$, $[11f_0 13f_0]$, $[13f_0 15f_0]$, and so on and so forth until reaching the boundary area of the spectrum, such that the last search window is the one the upper boundary of which is closest to the boundary of the spectrum without exceeding it (search windows below $7f_0$ are not defined, since there are no RSH in that area). The spectrum covers from 0 Hz to $100f_0$ Hz (the FFT gives the signal spectrum from 0 Hz up to the sampling frequency divided by 2, i.e., $200f_0/2$ Hz). According to a particular example in which the fundamental frequency $f_0$ is 50 Hz, the boundary of the spectrum is 5000 Hz and the last search window is [4850 Hz 4950 Hz], which corresponds to m=49, as with *m=50* the boundary of the spectrum is exceeded; so the RSH candidate harmonic search windows are [350 Hz 450 Hz], [450 Hz 550 Hz], [550 Hz 650 Hz], [650 Hz 750 Hz], and so on and so forth up to [4850 Hz 4950 Hz].

- Defining reduced RSH candidate harmonic search windows: The amplitude of the RSH candidate harmonic search windows is reduced on both sides to exclude odd multiples of the fundamental frequency, which can be significant. Preferably, said amplitude is slightly reduced. More preferably, 1.3 Hz are subtracted from the upper boundary and $0.26f_0$ are added to the lower boundary of the RSH candidate harmonic search windows. These corrections have been established experimentally, testing their proper operation with a database of 100 motors in the industry. The lower boundary has been corrected to a higher degree, as there is a higher likelihood that other harmonics that are not RSH will occur in said area.

- Identifying the possible rotor slot harmonics (also referred to as RSH candidate harmonics): Within each reduced RSH candidate harmonic search window, the algorithm identifies the maximum value as an RSH candidate harmonic and stores its frequency.

- Classifying in families: Next, the maximums located in the reduced RSH candidate harmonic search windows are classified by families. Based on the aforementioned, it is considered that a series of RSH candidate harmonics belongs to a family (i.e., they are linked to the same k index=1, 2, *3...)* if they are at the same distance from the boundary of the reduced search window (preferably, with a tolerance of 0.5 Hz); more specifically, from the upper boundary of the reduced search window in case of operating in motor mode, or from the lower boundary in case of operating in generator mode.

- Selecting the sets to be considered: That RSH family candidate harmonics with the most components is selected. In the case of a tie, all the tied families are selected. Each selected family is considered a set of RSH family candidate harmonics; and each component of each selected family is considered a RSH candidate harmonic.

*Calculating the parameter $O_V$ (step ii) and determining the parameter v associated with each component of the selected family or families (step iii).*
The method described in detail below is repeated for each RSH candidate harmonic belonging to each of the previously selected sets of RSH family candidate harmonics:

- Calculating $O_V$ (step ii): Prior to determining the parameter *v*, $O_V$ is calculated. Preferably, based on what was previously described, after having located an RSH candidate harmonic, the **odd** multiple of the fundamental frequency $O_V f_0$ is located in the spectrum to the right (in motor mode, which is the most common) or to the left (in generator mode); and, by knowing the frequency of the fundamental frequency $f_0$, the parameter $O_V$ is calculated.

- Determining the parameter *v* (step iii). Next, the iterative method whereby the parameter *v* of each RSH candidate harmonic of each set of candidates is fixed is described sequentially. According to a preferred embodiment, step iii) comprises:

  • Fixing the value of *v*: a value of *v*, preferably starting at -27 and ending at $O_V$ - 10 (-27, -25, ... -1, 1, ... , $O_V$ - 8, $O_V$ - 10) is selected, and the following method is performed for said fixed value (note that, as in practice, parameter v cannot take an even value, only odd values of *v* are considered; also note that since $O_V = kR/p \pm v$, a maximum value of $v = O_V$ - 10 implies a value minimum of $kR/p$ = 10):

    ➢ Calculating the slip: By using equation 0.6 with the value of v considered, the $O_V$ previously calculated, the fundamental frequency $f_0$, and the frequency of the RSH candidate harmonic, slip is determined.
    ➢ Calculating slip-derived values: The slip calculated in the preceding step is multiplied by 0.75 and 1.25 separately, thereby obtaining two slip-derived values, which are referred to herein as lower slip (0.75s) and upper slip (1.25s), respectively.
    ➢ Fault harmonic search bands: The lower slip and the upper slip obtained in the preceding step are used to determine one or more windows to search for one or more fault harmonics, respectively (for example, broken bar harmonics, mixed eccentricity harmonics, and/or dynamic eccentricity harmonics) by means of the respective theoretical formulas of the frequencies of said fault harmonics. Namely, to determine a fault harmonic search window, two calculations are performed with the corresponding theoretical formula of fault harmonic frequency in question: one of the calculations is performed by using the lower slip value as the slip value in said formula, resulting in a fault harmonic frequency value; and the other calculation is performed by using the upper slip value as the slip value in the theoretical frequency formula, resulting in another fault harmonic frequency value. The lowest and highest frequency values obtained are taken as the lower end and upper end, respectively, of the fault harmonic search window.

    According to a preferred embodiment, windows to search for up to 16 fault harmonics (8 for broken bars, 4 for mixed eccentricity, 2 for dynamic eccentricity, and the main harmonics for broken bars present in the demodulated current) are determined by means of the corresponding theoretical formulas which characterize said fault harmonics, as described below.
    First family of fault harmonics associated with broken bars for k=1 and k=2:

$$f_{BB1} = (1 \pm 2ks)f_0 \qquad\qquad (0.7)$$

    Second family of fault harmonics associated with broken bars for *k/p=5* and *k/p=7*:

$$f_{BB2} = \left[\frac{k}{p}(1-s) \pm s\right]f_0 \qquad\qquad (0.8)$$

    Fault harmonics associated with dynamic eccentricity for $n_D$=1 (where $n_D$ is the order of eccentricity):

$$f_{DE} = \left[\frac{kR \pm n_D}{p}(1-s) \pm v\right]f_0 \qquad (0.9)$$

It should be noted that according to the definition of parameter $O_V$ included in the present invention, the conventional theoretical formula 0.9 is as shown below:

$$f_{DE} = \left[\frac{p(O_v \mp v) \pm n_D}{p}(1-s) \pm v\right]f_0$$

Fault harmonics associated with mixed eccentricity for $k$=1 and $k$=2:

$$f_{ME} = \left[1 \pm k\frac{(1-s)}{p}\right]f_0 \qquad (0.10)$$

Fault harmonics associated with broken bars in the demodulated current for k=1 and $k$=2:

$$f_{BB,demod} = 2ksf_0 \qquad (0.11)$$

Next, a descriptive example in which the first fault harmonic search window for the first family of fault harmonics associated with broken bars is determined is described:

The theoretical formula characterizing said harmonic is $f_{BB} = (1 - 2s)f_0$ (k=1 has a negative sign); so the search window in this case is $[(1 - 2 \cdot 1.25s)f_0 \ (1 - 2 \cdot 0.75s)f_0]$.

➢ Locating the fault harmonic or harmonics: The maximum within each fault harmonic search window is calculated.
➢ Validating the chosen value of $v$: If the maximum of a fault harmonic search window is close to the center of said search window (preferably at a distance of less than 7% of the amplitude of the search window), the search window properly positions the fault harmonic and said value of v is considered valid to locate said fault harmonic.

- Iteration: Another value of v is selected, and the method of the preceding step is repeated, with the iteration preferably ending when the interval $[-27, ... , O_V - 10]$ has been covered.

- Definitive value of $v$: For a given RSH candidate harmonic, the value that has correctly located the largest number of fault harmonics is chosen as a definitive value of $v$ (in the case of a tie, the lowest parameter v is chosen).

As mentioned above, the method is repeated for all the RSH candidate harmonics of each of the sets of RSH family candidates. Therefore, to perform the iteration and determine the value of the parameter v for each RSH candidate harmonic of the same set of candidates, a novel criterion based on information already available in the machine being analyzed is used: verifying that the slip predicted by the RSH candidate harmonic is consistent with the position of the rest of the harmonics dependent on speed (namely, the fault harmonics), which can occur in an induction machine. This method does not introduce errors due, for example, to tolerances, or due to having performed a simplification or approximation, as is done in other commercial devices or techniques. Furthermore, it has the added advantage that, despite being fault harmonics, they also usually occur in healthy conditions, as all machines inherently have a certain level of both electrical and constructive asymmetry (rotor winding imperfections and eccentricities), which confers greater robustness to the method (at least some of these harmonics occur).

*Validating the family and consistency of results (step iv).*

After finishing with all the sets of RSH family candidates, and after having assigned a definitive value of v to each of the RSH candidate harmonics, which of all the sets of candidates is in fact an RSH family is determined. According to a preferred embodiment, this step (step iv) comprises the following actions:

Firstly, those sets of candidates in which one of the RSH candidate harmonics fails to predict the position of any of the fault harmonics for any parameter v are discarded (the expression *"fails to predict the position of any of the fault harmonics for any parameter v"* must conceptually be understood in the sense that no value of v is valid as explained above in the section on "Validating the chosen value of *v*"). In other words, if there is an RSH candidate harmonic belonging to the set of candidates considered such that, when testing with the different parameters *v,* there is no parameter *v* that works for at least one fault harmonic, then this RSH candidate harmonic is not an RSH and the set of candidates is discarded. If this occurs for each of the selected sets of candidates: said sets in the spectrum are filtered; RSH candidate harmonics are identified again by recalculating the maximum value for each reduced search window considered, as explained above in reference to step i); and the subsequent steps are repeated. However, it should be noted that, in the method of validating the device according to the preferred embodiment of the present invention, this situation does not occur for more than 90% of the analyzed cases.

Next, it is checked that the sets of candidates that have not been discarded for the above reason ensure the consistency of results. For two given RSH candidate harmonics belonging to the same set of candidates and separated by $2 \cdot f_0$, the setting of their respective parameters $v$ is consistent if their difference is equal to 2. In other words, if the definition of $O_v = kR/p \pm v$ is recovered, it can be written as $kR/p = O_v \mp v$. Two parameters $v$ associated with two $O_V$ are consistent with one another if, in the previous equation, they result in the same value of $kR/p$ (i.e., the same slots per pole pair $R/p$ multiplied by $k$). To ensure the consistency of a given set of candidates, the algorithm calculates the % of the frequency of the setting most repeated with respect to the total number of settings. If this value is less than 50%, the set of candidates is ruled out. If this occurs for all the sets of candidates: said sets in the spectrum are filtered; RSH candidate harmonics are identified again by recalculating the maximum value for each reduced search window considered, as explained above in reference to step i); and the subsequent steps are repeated. Namely, according to a preferred embodiment, the following steps are performed to ensure the consistency of results:

- The number of slots per pole pair multiplied by the k index is calculated by using the equation $kR/p = O_v \mp v$ for each RSH candidate harmonic of the set of candidates considered.
- The value of $k\,R/p$ most repeated in said set of candidates is retained.
- The consistency ratio, defined as the percentage of RSH candidate harmonics of the set of candidates considered that have resulted in the most repeated value of $k\,R\,/\,p$ is calculated.

  • If the consistency ratio is less than 50%, the set of candidates is ruled out.
  • If this occurs for all the sets of candidates: said sets in the spectrum are filtered; RSH candidate harmonics are identified again by recalculating the maximum value for each reduced search window considered, as explained above in reference to step i); and the subsequent steps are repeated.
  • If the consistency ratio is greater than 50%, the parameter $v$ of the RSH candidate harmonics of the set of candidates is considered a valid parameter.

Then, after having assigned to each RSH candidate harmonic of each set of candidates a valid parameter $v$ and all the sets of candidates have a consistency ratio greater than 50%, the following criteria for selecting the definitive RSH family from the sets of candidates considered valid are applied:

- Firstly, the set of candidates with the highest consistency ratio is selected.
- In the case of a tie among several sets of candidates, that set of candidates with the highest consistency ratio and with the highest average number of matches is selected. The number of matches for an RSH candidate harmonic of a given set of candidates is defined as the number of fault harmonics that are located by using the slip estimated based on this RSH candidate harmonic according to the rules described above. The average number of matches for a set of candidates is defined as the average of all the numbers of matches associated with the respective RSH candidate harmonics of said set of candidates. According to a clarifying example in which a set of candidates has three RSH candidate harmonics, the harmonic candidate 1 locates 5 fault harmonics, the harmonic candidate 2 locates 6 fault harmonics, and the harmonic candidate 3 also locates 5 fault harmonics: the average number of matches for this set of candidates is (5+6+5)/3=5,33.
- In case of a second tie, the set of candidates with the highest consistency ratio, the highest average number of matches, and with the component with the highest amplitude is selected.

Finally, after having selected the definitive family, the inconsistent parameters $O_V$ and $v$ thereof (those the setting of which does not coincide with the most repeated) are ruled out, so their associated RSH are ruled out; and the consistent parameters are stored.

*Estimating the average operating speed (step v).*

Before explaining the method of estimating the average operating speed, some issues are described below by way of clarification:

- According to the preferred embodiment, when step iv) ends, the true RSH family of the machine is located, and the parameters $O_V$ and $v$ of the rotor slot harmonics (RSH) of said family are determined. These parameters are used to estimate the average operating speed. Based on this, steps i), ii), iii), and iv) herein are referred to as "steps of characterizing"; and the result of these steps is referred to as "characterization". When an asynchronous machine is analyzed for the first time, it is necessary to perform the characterization thereof, and it is also advisable to do so again every so often, since over time and due to a change in the operating conditions of the machine (for example, due to the degradation of the machine), it is possible that the number of detectable RSH may change.

- Having located the RSH in the characterization does not mean that the exact frequency thereof in future measurements will be known, since they can change if the operating conditions change. In any case, locating the RSH in the characterization implies knowing, at any given time, the area of the spectrum where the RSH occur (around which multiple of the fundamental frequency each RSH can be found), as well as the parameters $O_V$ and $v$ thereof, which allows knowing where to look and to be clear that what is going to be found is an RSH.

- According to the preferred embodiment, locating an RSH in the characterization means knowing at which multiple of the fundamental frequency it is located (i.e., knowing $O_V f_0$, which is the frequency of said multiple of the fundamental frequency, which is the same as knowing $O_V$, since $f_0$ is quickly calculated as it is always the frequency of the highest peak in the spectrum), assigning its parameter $v$ and having verified that the slip it predicts is consistent with the frequencies of the fault harmonic or harmonics present in the machine that also depend on the slip (i.e., that it is indeed an RSH). After having determined these parameters, they are stored in a database and referenced to said machine. Therefore, every time a new estimation of the speed of that machine is to be made, it can be done based on the stored parameters without the need to go through the characterization (although as mentioned above, it is convenient to repeat it from time to time). In other words, after having characterized the machine, subsequent analyses of the same machine are much simpler. In summary, step c) is greatly simplified.

- Evidently, the first time a machine is analyzed, the speed is estimated almost simultaneously to the steps of characterizing, so the powering/loading conditions are the same and, accordingly, the RSH detected in the steps of characterizing are the same as those in the step of estimating the speed. However, it is possible that, over time (for example, months), the speed may have to be estimated again, but this time the machine operates in other conditions and therefore the detectable RSH may not be exactly the same (most would be). Therefore, it would seem logical, in theory, that every time a new estimation is to be performed, the characterization of the machine would be performed; but this is not efficient due to the long capture time required by the characterization, and therefore the high consumption of memory and computing time. Therefore, it is more efficient to perform the estimation of the speed as described below, because by precisely knowing the areas of the spectrum in which the RSH are located (as parameters $O_V$ and $v$ are known), it is not necessary to perform the entire characterization process, which requires going through the entire spectrum.

- During the time interval of the capture of a current signal, the operating speed of the machine is not perfectly stable (it does not have a perfectly constant value), but rather it can slightly vary, and in fact, it always varies a little (there is no state in which the speed is perfectly constant). Therefore, when referring herein to average speed, reference is being made to the average speed during the current signal capture interval. When analyzing what the algorithm according to the preferred embodiment does: the frequency of an RSH is a function of speed and, therefore, during the time of the current signal capture, the frequency thereof varies in accordance with the speed of the machine. However, a single frequency value is extracted from the FFT for each RSH: the frequency where there is a higher peak, even though there may be smaller peaks to the sides due to speed oscillations. This unique frequency value in the case of RSH translates into a unique speed value, and given that this speed value is assigned to the time that the capture lasts, that speed is also referred to herein as the average speed in that time interval.

After the clarifications made, the method of estimating the average operating speed (step v) is described below.

According to a preferred embodiment, after having located around which multiples of the fundamental frequency the RSH are found for a given machine (which is defined by its corresponding parameters $O_V$), and its parameters $v$ are identified, every time the average speed is to be estimated or a diagnosis is to be performed, the algorithm establishes an exact RSH search window to determine the exact frequency of each of the RSH located in the characterization. Then, it estimates the speed based on each of them. Then, it applies a method for ruling out those detected harmonics which may not be an RSH, as the powering and/or loading conditions may have changed with respect to the first measurement in which the sets [$O_V$ and $v$] were determined and, therefore, it is possible that one of the RSH is no longer the highest harmonic in its search band. Finally, after having located the valid RSH, the RSH used to estimate the average operating speed is associated with parameter $v$ having a lower value, since the lowest error is thereby achieved during the estimation of the speed; according to an alternative option, any one valid RSH is used to estimate the average operating speed.

Next, described sequentially is step v) of estimating the average operating speed which, according to a more preferred embodiment, comprises the following sub-steps:

- Search band: An exact RSH search window (calculated with equation 0.4 above) is established for each of the RSH determined in step iv) (i.e., for each of the RSH located in the characterization), associated with its parameters v and $O_V$, the boundaries of which are preferably determined as follows:

  • The lower boundary of the exact RSH search window is the value of the frequency of the RSH determined in step iv) when $s=s_N$ (where $s_N$ is the nominal slip value), multiplied by a correction factor of 1.57 (to avoid problems due to the tolerance in the value of $s_N$ in the nameplate).
  • The upper boundary of the exact RSH search window is the value of the frequency of the RSH determined in step iv) when s=0 (no-load), by subtracting 0.5 Hz (to prevent the upper boundary from coinciding with a winding harmonic).

- Locating the rotor slot harmonics (RSH): Each RSH is located by means of detecting the maximum value within its corresponding search band (exact RSH search window indicated in the preceding paragraph).

- Estimating the slip and the speed associated with each RSH: After having determined the frequency of the RSH, the slip (s) associated with each RSH is calculated by using equation 0.6 (where v and $O_V$ are known) and the average speed (n) is calculated based on the slip (s).

- Determining valid estimations: Those estimations of the average speed that depart from the median by more than three absolute median deviations are ruled out.

- Selecting the speed estimation: From those valid estimations, the average speed estimation and the corresponding slip from the RSH with the lowest parameter *v* are finally used.

Optionally, the method for estimating the average operating speed of the machine (step v) can dispense with the sub-steps corresponding to establishing exact RSH search windows, and locate the RSH. This option may be advantageous, for example, in cases in which the characterization and the estimation of the average speed are performed without a time lapse between them (almost simultaneously), such as the first time a machine is analyzed, since, as discussed above, the powering/loading conditions **do** not change and, accordingly, the RSH detected in the steps of characterizing are the same as those in the step of estimating the average speed. Based on what has been described, according to a particular embodiment in which the characterization and the estimation of average operating speed of a machine are performed without a time lapse between them, the method of estimating average speed (step v) comprises the aforementioned sub-steps of "Estimating the slip and the speed associated with each RSH" based on the RSH detected in the characterization, followed by "Determining valid estimations" and "Selecting the estimation of speed". According to this particular embodiment (characterization and estimation of average speed without a time lapse between them), a first signal for the characterization and subsequently a second signal for the estimation of the average speed (and optionally the diagnosis) is not captured, but rather a single current signal is captured for all of it.

*Positioning and determining the amplitude of fault harmonic or harmonics (step d).*

The diagnosis of the machine can be performed based on the analysis of one or more fault harmonics. According to a preferred embodiment, step d) comprises the following sub-steps:

- After having estimated the average operating speed *(n)* in step c), the frequency of each fault harmonic is determined by using the slip (s) associated with said average speed in the theoretical formula of frequency of the corresponding fault harmonic (for example, fault harmonic associated with broken bars, fault harmonic associated with mixed eccentricity, etc.).
  According to a more preferred embodiment, the frequency of up to 16 fault harmonics (8 for broken bars, 4 for mixed eccentricity, 2 for dynamic eccentricity, and the main harmonics of broken bars present in the demodulated current) can be determined by means of the corresponding theoretical formulas of frequency, which have already been mentioned above in reference to step iii); i.e.: first family of fault harmonics associated with broken bars for k=1 and *k*=2 according to formula (0.7); second family of fault harmonics associated with broken bars for *k/p*=5 and *k/p*=7 according to formula (0.8); fault harmonics associated with dynamic eccentricity for $n_D$=1 according to formula (0.9); fault harmonics associated with mixed eccentricity for k=1 and k=2, according to formula (0.10); and fault harmonics associated with broken bars in the demodulated current for k=1 and *k*=2 according to formula (0.11).
- With the frequency of the fault harmonic or harmonics, the corresponding position and amplitude thereof in the spectrum is determined.
- The diagnosis is provided based on the position and amplitude of the fault harmonic or harmonics (generally, the higher the amplitude of a fault harmonic is, the more severe the fault is).

The device and method according to the preferred embodiments of the invention described above can be applied to various fields, such as, for example, the diagnosis of faults in induction motors and the estimation of speed in testing of submerged pumps with asynchronous motors.

In the case of induction motors, the device disclosed herein can be used for the diagnosis of broken bars, eccentricities, and short circuits between coils of the stator, as well as other faults that generate harmonics dependent on speed in the current spectrum of the induction motor. Furthermore, as a result of its design features as a non-invasive device with data transmission capability, which is furthermore accurate, automatic and of general applicability, it is ideal for continuous monitoring of the state of the motor in an industry 4.0 context, in which context the aim is to have as much information as possible about all the elements of the production system in order to be able to prevent and solve any fault before it becomes catastrophic.

In the case of submerged pumps, the device and method disclosed herein overcome one of the biggest problems that manufacturers of submerged pumps face during testing which allow obtaining the efficiency curves thereof: the inability to perform reliable speed measurements through optical encoders because the pump is submerged. Furthermore, even if the motor test were not being performed completely submerged, the high precision provided by the method according to the present invention, its robustness, its low cost, as well as its ability to track speed over time, make it preferable to any physical sensor intended to be used for the same purpose.

As a summary of the main advantages of the method and device disclosed herein with respect to the prior art, it should be noted that it is the first robust, precise, and automatic device for the diagnosis of broken bars and eccentricities in induction machines that does not require user intervention at any time.

It is also the first device based on the detection of rotor slot harmonics (RSH) that does not require knowing the number of rotor slots beforehand, nor does it have to determine them in an invasive manner or by means of off-line testing, all as a result of a novel analysis of the frequencies of these harmonics.

Moreover, it is the first device that uses the presence of up to 16 fault harmonics (8 for broken bars, 4 for mixed eccentricity, 2 for dynamic eccentricity, and the main harmonics for broken bars present in the demodulated current), to confirm the correct location of the RSH, as well as the correct estimation of the associated parameters ($O_V$ and v), which confers to it substantial robustness, as it ensures that the estimation of the slip finally performed is consistent for this entire set of harmonics.

Lastly, it is the first device with sufficient capacity to provide a precise and dynamic speed estimation (information every few seconds) which can be used both as information to determine the performance curves of pumps working in submerged conditions, and for being able to detect load oscillations in the motor.

With respect to document WO2019167086 mentioned above, which constitutes the prior art closest to the invention disclosed herein, it should be noted that for estimating speed, the present method and device are based on rotor slot harmonics (RSH) which occur with a high amplitude and in an area of the spectrum that departs from load oscillation harmonics (which are highly detectable) and have a broad bandwidth (high precision). All this this represents a substantial advantage with respect to document WO2019167086, which is based on mixed eccentricity harmonics.

Moreover, the method of the present invention shows great robustness as a result of using not only one of the RSH, but rather all of those RSH which are in the spectrum (minimum number 2, average number 8, and maximum number 24), verifying that the results are consistent between each of the RSH, i.e., the $k \cdot R/p$ number obtained based on each $O_V$ and v *is* the same for all of them, and that the slips thereof allow locating the rest of the fault harmonics dependent on speed. Therefore, all the information available in the machine is used for the parameters $O_V$ and v to be consistent therewith. In contrast, the method of estimating speed described in document WO2019167086A1 only uses a single harmonic dependent on speed. This means that the method is not very robust, since the consistency of the estimation is not checked against the rest of the information available in the spectrum. Therefore, it can fairly easily give rise to erroneous estimations of speed due, for example, to having identified a harmonic as MEH when it was not one.

Moreover, the present invention allows estimating with high precision, and in a completely non-invasive manner, parameters $O_V$ and v. With these two parameters, the present invention can correctly position the dynamic eccentricity harmonics for diagnosing this fault. In contrast, the method for diagnosing dynamic eccentricity harmonics described in document WO2019167086A1 requires knowing beforehand the number of slots, which parameter is rarely known in the industry and which, up until now, required taking apart the machine or invasive testing to determine same.

Lastly, the present invention can position with high precision and in a non-invasive manner the fault harmonics as a result of its novel system of estimating speed. In contrast, the method described in document WO2019167086A1 uses a band that is too broad to locate the fault harmonic (4 Hz centered on the frequency calculated based on the estimation of the speed by means of mixed eccentricity harmonics). By using such a broad search band (even broader than the bandwidth of the fault harmonic), the possibilities of detecting other non-fault-associated harmonics increase. Therefore, reliability decreases.

Although specific embodiments of the present invention have been described in detail herein, one skilled in the art could easily apply changes and modifications to said embodiments based on the teachings disclosed herein and based on general knowledge in the art. All these evident modifications of the embodiments disclosed herein are intended to be comprised within the scope of protection of the present invention, defined only by the attached claims.

**Claims**

1. A non-invasive method for estimating the speed of an asynchronous machine, said method comprising the steps of:

   a) specifying a signal capture time;
   b) capturing a line current signal from the asynchronous machine during the capture time specified in step a);
   c) processing the current signal obtained in step b), and estimating the average operating speed by using equation 0.6, based on an automatic detection of the position of the rotor slot harmonics (RSH) using programmable processing means, assigning them the parameters $v$ and $O_V$;

   $$s = \frac{O_v f_0 - f_{RSH}}{[O_v \mp v] \cdot f_0} \rightarrow n = \frac{60 f_0}{p}(1 - s) \qquad (0.6)$$

   where

   $s$ is the slip,
   $O_v f_0$ is the multiple of the fundamental frequency over which a given RSH lies when the slip (s) is zero,
   $f_0$ is the fundamental frequency,
   $f_{RSH}$ is the frequency of the RSH,
   $v$ the order of the temporal harmonic present in the voltage generated by the corresponding RSH,
   $n$ is the average operating speed,
   $p$ is the number of pole pairs of the machine,
   $O_V$ is the order of the odd harmonic of the fundamental frequency immediately higher than the frequency of the detected RSH, in the case of the asynchronous machine operating in motor mode; or the order of the odd harmonic of the fundamental frequency immediately lower than the frequency of the detected RSH, in the case of the asynchronous machine operating in generator mode;
   with the particularity that $O_V$ relates to $f_{RSH,s=0}$ and to $f_0$ according to the following equation:

   $$O_v = \frac{f_{RSH,\,s=0}}{f_0}$$

   (0.5)

   where $f_{RSH,s=0}$ is the frequency of a given RSH when the slip (s) is zero.

2. The method according to claim 1, **characterized in that** it further comprises the step of displaying the results obtained by the method.

3. The method according to any of the preceding claims, **characterized in that** step c) comprises the following steps:

   i) locating sets of RSH family candidate harmonics associated with the same k index value, where k is a positive natural number, and taking into account that the RSH associated with the same k index value are separated the same distance with respect to the **odd** multiple of the immediately higher fundamental frequency in the case of the asynchronous machine operating in motor mode; or of the **odd** multiple of the immediately lower fundamental frequency in the case of the asynchronous machine operating in generator mode;
   ii) calculating the parameter $O_V$ associated with each RSH candidate harmonic of each located set of candidates, where $O_V$ is the order of the **odd** harmonic of the fundamental frequency immediately higher than the frequency of the RSH candidate harmonic, in the case of the asynchronous machine operating in motor mode; or the order of the **odd** harmonic of the fundamental frequency immediately lower than the frequency of the RSH candidate harmonic, in the case of the asynchronous machine operating in generator mode; with the particularity that $O_V$ relates to $f_{RSH,s=0}$ and to $f_0$ according to equation 0.5, where $f_{RSH,s=0}$ **is** the frequency of a given RSH candidate harmonic when the slip (s) is zero;
   iii) determining the parameter v associated with each RSH candidate harmonic of each located set of candidates;
   iv) determining which of all the sets of candidate harmonics is the true RSH family; and
   v) estimating the average operating speed $n$ by using equation 0.6.

4. The method according to claim 3, **characterized in that**, after having determined which of all the sets of candidates is the true RSH family in step iv), the parameters $O_V$ and v of RSH of said family are stored for later use, such that when the method is applied again at another time on the same machine, directly step v) of estimating the average operating speed n is performed based on the stored parameters $O_V$ and v, instead of performing steps i), ii), iii), and iv) again.

5. The method according to any of claims 3 or 4, **characterized in that** step i) comprises:

   - obtaining the spectrum by calculating the fast Fourier transform (FFT) of the signal by applying zero-padding;
   - performing a prior filtering and estimation of the noise level;
   - filtering the noise;
   - defining RSH candidate harmonic search windows by subdividing the spectrum into windows of amplitude [$f_0$ (2m-1) $f_0$(2m+1)], where m is an integer increasing by one from 4, until covering the spectrum;
   - defining reduced RSH candidate harmonic search windows by reducing the amplitude of the RSH candidate harmonic search windows on both sides, to exclude the **odd** multiples of the fundamental frequency;
   - identifying RSH candidate harmonics, considering the maximum value within each reduced search window an RSH candidate harmonic;
   - classifying by families the maximums located in the reduced RSH candidate harmonic search windows, with those maximums with the same k index which are at the same distance from the boundary of the reduced search window being considered a family; and
   - selecting the family with the most components and in the case of a tie, selecting all the tied families.

6. The method according to claim 5, **characterized in that** step i) further comprises, after filtering the noise, in the case where the asynchronous machine is powered by a converter, the step of filtering the harmonics of said converter by estimating said harmonics through the theoretical formula thereof, by centering a band around same and removing everything contained in said band.

7. The method according to any of claims 3 to 6, **characterized in that** step iii) comprises performing the following actions on each RSH candidate harmonic of each located set of candidates:

   - fixing the value of v, by starting at -27 and ending at $O_V$-10, and performing the following sub-steps for said fixed value of v:

     • calculating the slip by applying to equation 0.6 the value of v considered, the value of $O_V$ previously calculated, the fundamental frequency $f_0$, and the frequency of the RSH candidate harmonic;
     • multiplying the slip calculated in the preceding sub-step by 0.75 and 1.25 separately, thereby obtaining two values referred to as lower slip and upper slip, respectively;
     • determining one or more fault harmonic search windows to search for one or more fault harmonics, respectively, by using the lower slip and the upper slip of the preceding sub-step in respective theoretical formulas of the frequencies of said fault harmonics;
     • locating the fault harmonic or harmonics by calculating the maximum within each fault harmonic search window;
     • if the maximum is close to the center of the corresponding fault harmonic search window the value of v to locate said fault harmonic is considered valid;

   - selecting another value for v and repeating the method of the preceding step, the iteration **ending after** covering the entire previously defined interval: [-27, ... , $O_V$-10]; and
   - choosing as the definitive value of v for the RSH candidate harmonic considered that which correctly locates the highest number of fault harmonics.

8. The method according to any of claims 5 and 7, **characterized in that** step iv) comprises the following steps:

   - those sets of candidates in which one of the RSH candidate harmonics fails to predict the position of any of the fault harmonics for any parameter v are discarded;
   - if this occurs for each of the sets of candidates selected, said sets in the spectrum are filtered, RSH candidate harmonics are identified again, and the subsequent steps are repeated;
   - it is checked that the sets of candidates that have not been discarded for the above reason ensure the consistency of results, according to the following sub-steps:

- the number of slots per pole pair multiplied by the k index is calculated by using the equation $kR/p=O_v \mp v$ for each RSH candidate harmonic of the set of candidates considered;
- the most repeated value of $k\,R\,/\,p$ in said set of candidates is retained;
- the consistency ratio, defined as the percentage of RSH candidate harmonics of the set of candidates considered that have resulted in the most repeated value of $k\,R\,/\,p$ is calculated;

   ➢ if the consistency ratio is less than 50%, the set of candidates is ruled out;
   ➢ if this occurs for all the sets of candidates, said sets in the spectrum are filtered, RSH candidate harmonics are identified again, and the subsequent steps are repeated;
   ➢ if the consistency ratio is greater than 50%, the parameter v of the RSH candidate harmonics of the set of candidates is considered a valid parameter;

- the following criteria for selecting the definitive RSH family from the sets of candidates considered valid are applied:

   • firstly, the set of candidates with the highest consistency ratio is selected;
   • in the case of a tie among several sets of candidates, that set of candidates with the highest consistency ratio and with the highest average number of matches is selected, defining the number of matches for an RSH candidate harmonic of a given set of candidates as the number of fault harmonics that are located by using the slip estimated based on this RSH candidate harmonic; and defining the average number of matches for a set of candidates as the average of all the numbers of matches associated with the respective RSH candidate harmonics of said set of candidates;
   • **in case** of a second tie, the set of candidates with the highest consistency ratio, the highest average number of matches, and with the RSH candidate harmonic with the highest amplitude is selected;

- finally, after having selected the definitive family, the inconsistent parameters $O_V$ and v thereof are ruled out, understanding inconsistent parameters to be those the setting of which does not coincide with the most repeated, and the consistent parameters are stored.

9. The method according to claims 6 and 7, **characterized in that** step iv) comprises the following steps:

- those sets of candidates in which one of the RSH candidate harmonics fails to predict the position of any of the fault harmonics for any parameter v are discarded;
- if this occurs for each of the sets of candidates selected, said sets in the spectrum are filtered, RSH candidate harmonics are identified again, and the subsequent steps are repeated;
- it is checked that the sets of candidates that have not been discarded for the above reason ensure the consistency of results, according to the following sub-steps:

   • the number of slots per pole pair multiplied by the k index is calculated by using the equation $kR/p=O_v \mp v$ for each RSH candidate harmonic of the set of candidates considered;
   • the most repeated value of $k\,R\,/\,p$ in said set of candidates is retained;
   • the consistency ratio, defined as the percentage of RSH candidate harmonics of the set of candidates considered that have resulted in the most repeated value of $k\,R\,/\,p$ is calculated;

   ➢ if the consistency ratio is less than 50%, the set of candidates is ruled out;
   ➢ if this occurs for all the sets of candidates, said sets in the spectrum are filtered, RSH candidate harmonics are identified again, and the subsequent steps are repeated;
   ➢ if the consistency ratio is greater than 50%, the parameter v of the RSH candidate harmonics of the set of candidates is considered a valid parameter;

- the following criteria for selecting the definitive RSH family from the sets of candidates considered valid are applied:

   • firstly, the set of candidates with the highest consistency ratio is selected;
   • in the case of a tie among several sets of candidates, that set of candidates with the highest consistency ratio and with the highest average number of matches is selected, defining the number of matches for an RSH candidate harmonic of a given set of candidates as the number of fault harmonics that are located by using the slip estimated based on this RSH candidate harmonic; and defining the average number of matches for a set of candidates as the average of all the numbers of matches associated with the respective RSH candidate harmonics of said set of candidates;

• in case of a second tie, the set of candidates with the highest consistency ratio, the highest average number of matches, and with the RSH candidate harmonic with the highest amplitude is selected;

- finally, after having selected the definitive family, the inconsistent parameters $O_V$ and $v$ thereof are ruled out, understanding inconsistent parameters to be those the setting of which does not coincide with the most repeated, and the consistent parameters are stored.

10. The method according to any of claims 3 to 9, **characterized in that** step v) comprises:

- establishing an exact RSH search window calculated with the equation $f_{RSH} = O_v f_0 - [O_v \mp v] \cdot s \cdot f_0$ for each of the RSH determined in step iv) associated with the parameters $v$ and $O_V$ thereof, the boundaries of which are determined as follows:

• the lower boundary of the exact RSH search window is the value of the frequency of the RSH determined in step iv) when $s=s_N$, multiplied by a correction factor of 1.57, where $s_N$ is the nominal slip value;
• the upper boundary of the exact RSH search window is the value of the frequency of the RSH determined in step iv) when s=0, by subtracting 0.5 Hz;

- locating the RSH by means of detecting the maximum value within each exact RSH search window; and
- estimating the slip associated with each RSH by using equation 0.6 and, based on the slip, the average speed;
- determining the valid estimations, by ruling out those average speed estimations that depart from the median by more than three absolute median deviations; and
- selecting from the valid estimations that average speed estimation performed based on the RSH with a lower parameter v.

11. The method according to any of claims 1 to 10, **characterized in that** it comprises a step d), in which, based on the average speed estimated in step c), the position and amplitude of one or more fault-associated harmonics, the spectrum frequency of which depends on the speed, is determined, and a diagnosis based on the result obtained is provided, step d) comprising the following sub-steps:

- based on the average speed estimated in step c), the frequency of each fault harmonic is determined by using the slip (s) associated with said average speed in the theoretical formula of frequency of the corresponding fault harmonic;
- based on the frequency of the fault harmonic or harmonics the corresponding position and amplitude thereof in the spectrum is determined; and
- the diagnosis is provided based on the position and amplitude of the fault harmonic or harmonics.

12. The method according to claim 11, **characterized in that** it further comprises the step of providing an alarm in the case of detecting a fault during step d) of diagnosis.

13. The method according to any of claims 11 or 12, **characterized in that** it further comprises the step of storing at least one piece of data selected from the estimated average speed, the position and amplitude of the harmonics, and the result of the diagnosis.

14. A device for estimating the speed of an asynchronous machine using a method according to any one of the preceding claims, comprising:

- a data acquisition system (14) for acquiring data by means of a current probe (16), the current probe (16) being suitable for capturing the physical signal of one of the line currents of the asynchronous machine, and the data acquisition system (14) being configured to convert the physical signal captured by the current probe (16) into a digital signal;
- a control unit (10) configured to control the data acquisition system (14); and
- programmable processing means suitable for executing step c) of the method.

15. The device according to claim 14, wherein the programmable processing means are also suitable for executing step d) of the method.

**16.** The device according to any of claims 14 and 15, **characterized in that** the control unit (10) is a mini-computer.

**17.** The device according to any of claims 14 to 16, **characterized in that** the programmable processing means are incorporated in the control unit (10).

**18.** The device according to any of claims 14 to 16, **characterized in that** the programmable processing means are independent of the control unit (10) and are remotely connected to said control unit (10).

**19.** The device according to any of claims 14 to 18, **characterized in that** it further comprises display means (12) for displaying the results obtained by the programmable processing means.

**20.** The device according to claim 19, **characterized in that** the display means (12) are incorporated in the control unit (10).

**21.** The device according to claim 19, **characterized in that** the display means (12) are independent and are remotely connected to the control unit (10).

**22.** The device according to any of claims 14 to 21, **characterized in that** it further comprises alarm means for providing an alarm in the case of detecting a fault in the asynchronous machine by means of the programmable processing means.

**23.** The device according to any of claims 15 to 22, **characterized in that** it further comprises a storage unit to store at least one piece of data selected from the estimated average speed, the position and amplitude of the harmonics, and the result of the diagnosis.

FIG. 1

FIG. 2

## INTERNATIONAL SEARCH REPORT

| International application No. |
|---|
| PCT/ES2023/070272 |

### A. CLASSIFICATION OF SUBJECT MATTER

*G01R31/34* (2020.01)
*H02K11/21* (2016.01)
According to International Patent Classification (IPC) or to both national classification and IPC

### B. FIELDS SEARCHED

Minimum documentation searched (classification system followed by classification symbols)
G01R, H02K

Documentation searched other than minimum documentation to the extent that such documents are included in the fields searched

Electronic data base consulted during the international search (name of data base and, where practicable, search terms used)

INVENES, EPODOC, WPI, IEEE, INSPEC, COMPENDEX

### C. DOCUMENTS CONSIDERED TO BE RELEVANT

| Category* | Citation of document, with indication, where appropriate, of the relevant passages | Relevant to claim No. |
|---|---|---|
| A | (ISAKOV et al.) "Multi-phase Induction Machine Speed Estimation Method Using Rotor Slot Harmonics". IEEE EUROCON 2019-18th International Conference on Smart Technologies. 01/07/2019 doi:10.1109/EUROCON.2019.8861970 | 1-23 |
| A | (BONET-JARA et al.) "Sensorless Speed Estimation for the Diagnosis of Induction Motors via MCSA. Review and Commercial Devices Analysis". Sensors 2021, 21, 5037. 21/07/2021 https://doi.org/10.3390/s21155037 | 1-23 |
| A | (CHIRINDO et al.) "Analysis of Non-Intrusive Rotor Speed Estimation Techniques for Inverter-Fed Induction Motors". IEEE TRANSACTIONS ON ENERGY CONVERSION, Vol. 36, N° 1, Pages 338–347. 07/07/2020 SSN 0885-8969, doi:10.1109/TEC.2020.3007409 | 1-23 |

☒ Further documents are listed in the continuation of Box C.          ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance. | | |
| "E" | earlier document but published on or after the international filing date | | |
| "L" | document which may throw doubts on priority claim(s) or which is cited to establish the publication date of another citation or other special reason (as specified) | "X" | document of particular relevance; the claimed invention cannot be considered novel or cannot be considered to involve an inventive step when the document is taken alone |
| "O" | document referring to an oral disclosure use, exhibition, or other means. | "Y" | document of particular relevance; the claimed invention cannot be considered to involve an inventive step when the document is combined with one or more other documents , such combination being obvious to a person skilled in the art |
| "P" | document published prior to the international filing date but later than the priority date claimed | "&" | document member of the same patent family |

| Date of the actual completion of the international search | Date of mailing of the international search report |
|---|---|
| 18/07/2023 | **(19/07/2023)** |
| Name and mailing address of the ISA/ <br><br> OFICINA ESPAÑOLA DE PATENTES Y MARCAS <br> Paseo de la Castellana, 75 - 28071 Madrid (España) <br> Facsimile No.: 91 349 53 04 | Authorized officer <br> F. Olalde Sánchez <br><br><br> Telephone No. 913498469 |

Form PCT/ISA/210 (second sheet) (July 2022)

## INTERNATIONAL SEARCH REPORT

International application No.

PCT/ES2023/070272

C (continuation). DOCUMENTS CONSIDERED TO BE RELEVANT

| Category * | Citation of documents, with indication, where appropriate, of the relevant passages | Relevant to claim No. |
|---|---|---|
| A | (PETRIC et al.) "High-performance speed estimation of induction machines based on adaptive filtering". IET Electric Power Applications, , Vol. 14, N° 4, pages 695-704, 14/02/2020 ISSN 1751-8660, doi:10.1049/iet-epa.2019.0609 | 1-23 |
| A | (ZHANG et al.) "Sensorless speed estimation of mains-fed induction motors for condition monitoring using motor relays". 2015 IEEE Energy Conversion Congress and Exposition (ECCE), pages 2840-2845, 20/09/2015 doi:10.1109/ECCE.2015.7310058 | 1-23 |

Form PCT/ISA/210 (continuation of second sheet) (July 2022)

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2019167086 A1
- CN 111398814 A

- CN 11398814 A
- US 2019324084 A1
- WO 2019167086 A

**Non-patent literature cited in the description**

- Analysis of Non-Intrusive Rotor Speed Estimation Techniques for Inverter-Fed Induction Motors. **CHIRINDO MATHEWS** ; **KHAN MOHAMED A** ; **BARENDSE PAUL**. IEEE TRANSACTIONS ON ENERGY CONVERSION. IEEE SERVICE CENTER, vol. 36, 338-347